# EUROPÄISCHE PATENTSCHRIFT

(11) **EP 1 810 077 B1**
(45) Veröffentlichungstag und Bekanntmachung des Hinweises auf die Patenterteilung: **07.01.2009**
(21) Anmeldenummer: 05804614.5
(22) Anmeldetag: 02.11.2005
(51) Int. Cl.: G02F 1/153

(54) **PLATINE MIT EINEM ELEKTROCHROMEN BAUTEIL UND HERSTELLUNGSVERFAHREN DAZU**
PRINTED CIRCUIT BOARD WITH AN ELECTROCHROMIC COMPONENT AND PRODUCTION METHOD THEREFOR
PLATINE A COMPOSANT ELECTROCHROME ET PROCEDE DE PRODUCTION CORRESPONDANT

(30) Priorität: 12.11.2004 DE 102004054809
(43) Veröffentlichungstag der Anmeldung: 25.07.2007
(73) Patentinhaber: SIEMENS AKTIENGESELLSCHAFT, 80333 München (DE)
(72) Erfinder: BRABEC, Christoph, A-4040 Linz (AT); HAUCH, Jens, 90562 Heroldsberg (DE); WERNER, Marco, 81249 München (DE)
(86) Internationale Anmeldenummer: PCT/EP2005/055702
(87) Internationale Veröffentlichungsnummer: WO 2006/051058

(56) Entgegenhaltungen:
- GB-A- 1 495 568
- US-A- 5 293 546
- KRISTIANSEN H ET AL: "OVERVIEW OF CONDUCTIVE ADHESIVE INTERCONNECTION TECHNOLOGIES FOR LCD'S" IEEE TRANSACTIONS ON COMPONENTS, PACKAGING AND MANUFACTURING TECHNOLOGY: PART A, IEEE SERVICE CENTER, PISCATAWAY, NJ, US, Bd. 21, Nr. 2, Juni 1998 (1998-06), Seiten 208-214, XP000775239 ISSN: 1070-9886

## Beschreibung

Die vorliegende Erfindung betrifft eine Ansteuerung für ein elektrochromes Bauteil, insbesondere die Verbindung zwischen dem elektrochromen Bauteil und der Ansteuerung, sowie die Herstellung einer Leiterplatte.

Ein bislang bekanntes elektrochromes Bauteil wird über zumindest zwei externe, vorzugsweise metallische Leitungen, die an eine konventionelle Elektronik angelötet sind, angesteuert. Je nach Komplexität des gesamten Elements(device), beispielsweise eines Passiv-Matrix-Displays, liegen bis zu Tausende von Anschlüssen dieser Art vor, die alle in diffizilen Lötarbeitsschritten gefertigt werden müssen oder auf andere Art mit der Ansteuerelektronik verbunden werden müssen.(z. B. die Kontaktierung bei LCD Displays wird über uniaxial leitende, teure Schaumstoffe gemacht)

Nachteilig sind insbesondere die Herstellungskosten dieser Elemente, die nicht zuletzt deswegen so hoch sind, weil die externen Leitungen alle verbunden werden müssen.

Aufgabe der Erfindung ist es daher, Elemente (devices) mit elektrochromen Bauteilen zur Verfügung zu stellen, die kostengünstig und massenfertigungstauglich herstellbar sind.

Diese Aufgabe wird durch den Gegenstand der abhängigen und unabhängigen Ansprüche sowie durch die Beschreibung, die Figur, die Beschreibung zu der Figur und die Beispiele belegt.

Gegenstand der Erfindung ist ein Element mit elektrochromem Bauteil, wobei das elektrochrome Bauteil mit der Ansteuerungselektronik auf einer Platine angeordnet ist. Außerdem ist Gegenstand der Erfindung ein Verfahren zur Herstellung eines Elements mit elektrochromem Bauteil, wobei auf einer Leiterplatte oder Platine eine untere Elektrode aufgebracht wird und die so vorbereitete Leiterplatte anschließend mit einer vorgefertigten Sichtelektrode verbunden wird, wobei die aktive Schicht, die elektrochrome, ionenleitende und ionenspeichernde Funktion kombiniert, entweder auf der Platinenseite oder auf der Sichtelektrodenseite aufgebracht sein kann.

Vorteilhafterweise wird die untere Anschlusselektrode des elektrochromen Bauteils auf einer konventionellen Leiterplatte oder Platine ausgelegt, wobei die Leiterplatte sowohl flexibel als auch starr sein kann. Für manche Anwendungen wird bevorzugt, dass die Platine flexibel ist. Dabei kann es erforderlich sein, dass, um eine Degradation der metallischen Anschlusselektrode, also beispielsweise einer Kupferelektrode, zu verhindern, diese mit Nickel, Gold und/oder PEDOT beschichtet ist(z.B. Au oder PEDOT).

Die Kontaktierung der Sichtelektrode des elektrochromen Bauteils findet über die Applikation eines elektrisch uniaxial leitenden Klebers statt.

Insbesondere bevorzugt wird dabei ein elektrisch uniaxial leitender Kleber, wie beispielsweise einer der Firma Loctite eingesetzt.

Nach einer vorteilhaften Ausführungsform ist zumindest auf einer Seite des elektrochromen Bauteils ein seitliches Anschlusspad vorgesehen, über das die Kontaktierung der Sichtelektrode des elektrochromen Bauteils mit den Anschlüssen auf der Leiterplatte erfolgt. Nach einer vorteilhaften Ausführungsform erfolgt dann die Kontaktierung der Sichtelektrode über das seitliche Pad mittels eines elektrisch uniaxial leitenden Klebers oder Klebestreifens.

Die Integration des elektrochromen Bauteils auf der Leiterplatte erfolgt sinnvollerweise nur mit der Sichtelektrode, also mit der semitransparenten Elektrode nach oben und der nicht transparenten Elektrode nach unten.

Zur Herstellung der Leiterplatte wird beispielsweise wie folgt vorgegangen:

Auf einer konventionellen Leiterplatte, die auch flexibel sein kann, wird die untere Elektrode eines elektrochromen Elements aufgebracht. Diese Elektrode ist beispielsweise aus Kupfer, unter Umständen aus einem mit Nickel und/oder Gold beschichtetem Kupfer. Auf diese untere Elektrode wird die aktive Schicht, die eine elektrochrome Schicht, eine Ionenleitschicht und eine Ionenspeicherschicht umfasst, aufgebracht. Anstelle der drei Schichten des elektrochromen Systems kann auch eine Schicht eines Materials aufgebracht werden, das alle drei Schichten miteinander verbindet, wie beispielsweise ein bekanntes elektrochromes Material. Zusätzlich sind auf der Leiterplatte seitliche Anschlusspads für die Kontaktierung der Sichtelektroden auf die Leiterplatte vorgesehen. Durch Aufkleben oder Laminieren wird die obere Sichtelektrode mit der Unterseite, der Leiterplattenseite, verbunden. Die Kontaktierung der Sichtelektrode mit der Leiterplatte findet danach vorzugsweise über die seitlichen Anschlusspads, insbesondere mittels eines elektrisch uniaxial leitenden Klebstoffes, statt.

Das elektrochrome "Herzstück" des Elements, das herkömmmlicherweise aus den drei bekannten Schichten der elektrochromen Schicht, der Ionenleitschicht und der Ionenspeicherschicht und neuerdings auch durch Applikation der einen Schicht aus dem aus der WO 02/075441 bekannten Material, gebildet wird, kann sowohl auf der Leiterplattenseite als auch auf der strukturierten Sichtelektrodenseite, wobei beispielsweise eine Abdeckfolie als Substrat eingesetzt werden kann, vor dem Zusammenfügen der oberen Sichtelektrodenseite mit der Leiterplatten- oder Platinenseite vorhanden sein. Insofern soll der Herstellungsprozess gemäß der vorliegenden Erfindung nicht eingeschränkt sein.

Ausführungsbeispiel[e] der Erfindung.
a) Bestückte oder unbestückte Platine/Flex-Platine mit EC-Display gefertigt aus dem aus der WO 02/075441 bekannten Material und einer ITO-Elektrode, über eine Klebung mit dem Substrat verbunden und zusätzlich seitlich durch einen elektrisch uniaxial leitenden Klebstoff kontaktiert.
b) Bestückte oder unbestückte Platine/Flex-Platine mit EC-Display gefertigt aus dem aus der WO 02/075441 bekannten Material und ITO-Elektrode, gleichzeitig seitlich verklebt und kontaktiert durch einen elektrisch uniaxial leitenden Klebstoff. Hierbei wird ein Klebeschritt während der Verarbeitung eingespart.
c) Bestückte oder unbestückte Platine/Flex-Platine mit EC-Display gefertigt in konventioneller EC-Technik (Ionenspeicher gedruckt auf Platine, EL, EC-Material, ITO-Elektrode), über eine Klebung mit dem Substrat verbunden und zusätzlich seitlich durch einen elektrisch uniaxial leitenden Klebstoff kontaktiert.
d) Bestückte oder unbestückte Platine/Flex-Platine mit EC-Display gefertigt in konventioneller EC-Technik (Ionenspeicher gedruckt auf Platine, EL, EC-Material, ITO-Elektrode), gleichzeitig seitlich verklebt und kontaktiert durch einen elektrisch uniaxial leitenden Klebstoff.

Im Folgenden wird die Erfindung noch anhand einer Figur, die eine beispielhafte Ausführungsform der Erfindung zeigt, näher erläutert:

Zu erkennen ist eine Platine 1, beispielsweise aus FR4 oder Polyimid, darauf eine untere Elektrode 2, beispielsweise aus Kupfer, das mit Nickel und/oder Gold beschichtet sein kann, darauf befindet sich die elektrochrome aktive Schicht 3, die beispielsweise aus dem aus der WO 02/075441 bekannten Kombinationsmaterial, darauf ist die Sichtelektrode 4 angeordnet, die beispielsweise aus ITO gefertigt sein kann und darauf ist in vorteilhafter Weise eine Abdeckfolie 5 angeordnet, die die gesamte Anordnung vor schädlichen Umwelteinflüssen schützt.

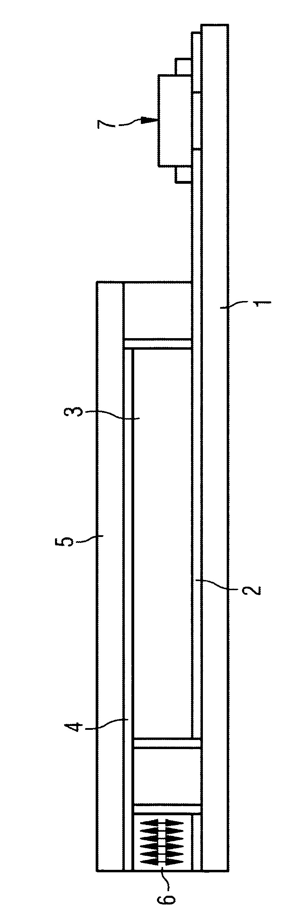

Die Verbindung der Sichtelektrode 4 mit der Platine 1 findet über die Applikation eines elektrisch uniaxial leitenden Klebstoffes statt, so dass das gesamte Bauelement massenfertigungstauglich in Dünnschichttechnologie herstellbar ist. Seitlich in der Figur 1 ist die Anschlussstelle 6, die einen uniaxial leitenden Kleber umfasst, zu sehen.

Bei 7 ist die Bestückung auf der Platine zu erkennen. Bei einem beispielhaften Verfahren zur Herstellung des Elements mit elektrochromem Bauteil wird auf einer Leiterplatte oder Platine eine untere Elektrode aufgebracht und die so vorbereitete Leiterplatte anschließend mit einer vorgefertigten Sichtelektrode verbunden, wobei die aktive Schicht, die elektrochrome, ionenleitende und ionenspeichernde Funktion kombiniert, entweder auf der Platinenseite oder auf der Sichtelektrodenseite vorbereitend aufgebracht sein kann.

Mit der Erfindung wird erstmals ein Verfahren vorgeschlagen, bei dem über wenige einfache Schritte ein elektrochromes Display mit konventioneller Leiterplattentechnologie kombiniert und in massenfertigungstauglicher Produktionsweise, bevorzugt in Dünnschichttechnologie, hergestellt werden kann. Alle Arbeitsschritte, die dazu nötig sind, setzen auf einer fertig bestückten Platine auf, so dass keinerlei Veränderungen in dem Herstellungsprozess der Platine erforderlich werden.

Die Platine kann vorab, eventuell auch noch durch Aufbringung des elektrochromen Materials, bestückt werden. Die Kontaktierung erfolgt später durch Applikation eines uniaxial leitenden Klebers auf seitlich angebrachte Anschlusspads. Die elektrochrome aktive Schicht wird dann im nächsten Schritt über einen Druckprozess, eine Serie von Druckprozessen oder über einen Laminationsprozess entweder auf der Platinenseite oder auf der Sichtelektrodenseite hergestellt. Im weiteren Verlauf werden dann die Sichtseite und die Unterseite (bzw. die Platinenseite) zusammengefügt und/oder miteinander verklebt. Als letzter Schritt wird die Sichtelektrode mit der Leiterplatte durch einen elektrisch uniaxial leitenden Klebstoff über die seitlichen Anschlusspads elektrisch verbunden.

Der Vorteil besteht unter anderem darin, dass durch das vorgestellte Verfahren und die vorgestellte Kombination einer Platine mit einem elektrochromen Bauteil beispielsweise elektrochrome Displays beliebiger Komplexität hergestellt werden können, ohne dass einzelne Verbindungen separat kontaktiert werden müssen. Der gesamte Herstellungsprozess soll massenfertigungstauglich durchgeführt werden.

## Patentansprüche

1. Element mit elektrochromen Bauteil auf einer Platine (1) mit der dazugehörigen Ansteuerungselektronik (7), das elektrochrome Bauteil eine elektrochrom aktive Schicht (3) zwischen einer unteren Anschlusselektrode (2) und einer oberen Sichtelektrode (4) umfassend, **dadurch gekennzeichnet, dass** der Kontakt zwischen der oberen Sichtelektrode und der unteren Anschlusselektrode zumindest auf einer Seite des elektrochromen Bauteils über ein seitliches Anschlusspad mittels eines uniaxial leitenden Klebstoffes (6) erfolgt.

2. Element mit elektrochromen Bauteil nach Anspruch 1, wobei die untere Anschlusselektrode des elektrochromen Bauteils Teil der bestückten Platine ist.

3. Element nach einem der vorstehenden Ansprüche, wobei die Platine flexibel ist.

4. Element nach einem der vorstehenden Ansprüche, wobei die elektrochrom aktive Schicht auf der bestückten Platine aufgedruckt ist.

5. Verfahren zur Herstellung eines Elements mit elektrochromen Bauteil, wobei auf einer Leiterplatte oder Platine (1) eine untere Elektrode (2) aufgebracht wird und die so vorbereitete Leiterplatte anschließend mit einer vorgefertigten Sichtelektrode (4) verbunden wird, wobei die aktive Schicht (3), die elektrochrome, Ionen leitende und Ionen speichernde Funktion kombiniert, entweder auf der Platinenseite oder auf der Sichtelektrodenseite aufgebracht wird.

6. Verfahren nach Anspruch 5, wobei die elektrochrom aktive Schicht aufgedruckt wird.

7. Verfahren nach einem der Ansprüche 5 oder 6, wobei die Verbindung der Schichten und die Kontaktierung der beiden Elektroden in einem Klebeschritt durchgeführt werden.

## Claims

1. Element with electrochromic component on a printed circuit board (1) with the associated control electronics (7), comprising the electrochromic component, an electrochromically-active layer (3) between a lower connection electrode (2) and an upper visible electrode (4), **characterized in that** the contact between the upper visible electrode and the lower connection electrode is made at least on one side of the electrochromic component via a lateral connection pad by means of a uniaxially-conductive adhesive (6).

2. Element with electrochromic component according to claim 1, with the lower connection electrode of the electrochromic component being a part of the equipped board.

3. Element according to one of the preceding claims, whereby the board is flexible.

4. Element according to one of the preceding claims, whereby the electrochromically-active layer is printed onto the equipped board.

5. Method for manufacturing an element with electrochromic component, whereby a lower electrode (2) is applied to a printed circuit board (1) and the printed circuit board prepared in this way is subsequently connected to a prefabricated visible electrode (4), whereby the active layer (3) that combines electrochrome, ion conducting and ion storing function is applied either to the board side or to the visible electrode side.

6. Method according to claim 5, whereby the electrochromically-active layer is printed on.

7. Method according to one of claims 5 or 6, whereby the connection of the layers and the contacting of the two electrodes is carried out in a gluing step.

## Revendications

1. Élément avec un composant électrochrome sur une carte (1), avec l'électronique d'amorçage associée (7), le composant électrochrome comprenant une couche à activité électrochrome (3) entre une électrode de raccordement inférieure (2) et une électrode en couche supérieure (4), **caractérisé en ce que** le contact entre l'électrode en couche supérieure et l'électrode de raccordement inférieure se produit au moins sur un côté du composant électrochrome par l'intermédiaire d'un plot de raccordement latéral au moyen d'une colle à conduction uniaxiale (6).

2. Élément avec un composant électrochrome selon la revendication 1, l'électrode de raccordement inférieure du composant électrochrome faisant partie de la carte équipée.

3. Élément selon l'une des revendications précédentes, la carte étant flexible.

4. Élément selon l'une des revendications précédentes, la couche à activité électrochrome étant imprimée sur la carte équipée.

5. Procédé de production d'un élément avec un composant électrochrome, une électrode inférieure (2) étant appliquée sur une plaquette de circuits imprimés ou carte (1) et la plaquette de circuits imprimés ainsi préparée étant ensuite reliée à une électrode en couche préfabriquée (4), la couche active (3), qui combine une fonction électrochrome conductrice d'ions et de stockage d'ions, étant appliquée du côté de la carte ou du côté de l'électrode en couche.

6. Procédé selon la revendication 5, la couche à activité électrochrome étant imprimée.

7. Procédé selon l'une des revendications 5 ou 6, la liaison des couches et l'établissement d'un contact entre les deux électrodes étant réalisés dans une étape de collage.
